# EUROPEAN PATENT APPLICATION

(11) **EP 3 855 580 A1**
(43) Date of publication of application: **28.07.2021**
(21) Application number: 20176098.0
(22) Date of filing: 22.05.2020
(51) Int. Cl.: H01R 13/6466, H01R 13/66, H01R 13/717, H01R 24/64, H05K 1/02, H01R 4/2433, H01R 13/52, H01R 107/00, H04Q 1/00, H05K 1/16, H05K 1/18, G01R 31/00

(54) **RJ45 CONNECTOR WITH LIGHT EMITTING DIODE AND COMPENSATION CIRCUIT**

(30) Priority: 21.01.2020 CN 202010070624
(71) Applicant: Zhejiang Deguang Technology Co., Ltd., Hangzhou City, Zheijiang Province 311700 (CN); Uniformatic, 93330 Neuilly-sur-Marne (FR)
(72) Inventor: JIA, Huating, 311700 Hangzhou City, Zhejiang Province (CN)
(74) Representative: Cabinet Chaillot

(57) **Abstract**

The present invention discloses an RJ45 connector with a light emitting diode and a compensation circuit, which comprises a voltage divider resistor R, a Zener diode D and the bi-color light emitting diode LED, wherein the voltage divider resistor R, the Zener diode D and the bi-color light emitting diode LED are serially connected between any two transmission lines of the RJ45 connector, and the capacitance compensation circuit is connected to the two transmission lines to perform capacitance compensation on the transmission lines. In the present invention, a structure of an existing RJ45 connector is used, without adding any contact or transmission line at the connector or additionally introducing a control host computer or supporting software to determine the connection state, which saves the cost of a wiring system greatly. Meanwhile, the compensation circuit is used to reduce the impact of the newly added voltage divider resistor R on the transmission performance of the transmission lines.

## Description

### TECHNICAL FIELD

The present invention relates to the field of network equipment, and in particular, to an RJ45 connector with a light emitting diode (LED) and a compensation circuit, which are applicable to a network wiring port.

### BACKGROUND

With the popularity of networks, RJ45 connectors used in integrated wiring are applied to most network terminals as critical parts for the standard configuration of a wired local area network, and an RJ45 connector is also an important link of the wiring process.

Usually, an integrated wiring method includes: firstly, assigning an ID number to each information point according to the distribution of the information points in a secondary detailed diagram of a construction project; then, numbering correspondingly and recording according to different positions of the points. These records frequently become incomplete for various reasons, such as incomplete records caused by dropped labels in the wiring process, lost records due to carelessness of a wiring person, a lost or incomplete work handover record, lost records due to computer replacement. A glued label may also drop due to an adhesive failure caused by dust, passing friction, a pull or a long duration. Due to the incomplete record and the dropped label, a lot of efforts and time may be spent on looking for the point during a line test after the project or during later network maintenance.

In an existing common method, an electronic distribution frame is adopted to solve the above defect. That is, a control host computer is added, contacts or wireless induction parts are added on an RJ45 male connector and an RJ45 female connector under a switching principle, an on/off state of a switch is determined by the host computer to further determine a connection state of the information point, and meanwhile, a connection table is added in the host computer to record the connection state thereof in real time. Although capable of solving the defect in the conventional integrated wiring process, the electronic distribution frame has the following disadvantages.

First, costs are increased due to the new function of the switching structures at the RJ45 male and female connectors of the electronic distribution frame as well as the control host computer, supporting software and the like added thereto; second, the electronic distribution frame is actually unable to detect a connection state on the switch side with a single-distribution structure, and a dual-distribution structure must be adopted in the wiring of a computer room, which doubles the numbers of some products used in the computer room; third, the electronic distribution frame has a higher requirement for the technical level of wiring and maintenance persons, who are required at least to be able to use supporting control software. Special control software for a system of the electronic distribution frame is incompatible with many management platforms with a higher security requirement, and therefore, with the system of the electronic distribution frame, only the wiring in the computer room can be managed, and the state of connection to a used terminal cannot be detected or managed.

Thus, in view of the above defects in the prior art, how to realize convenient and low-cost wiring management is a problem that urgently needs to be solved in the field.

### SUMMARY

An object of the present invention is to provide an RJ45 connector with a light emitting diode and a compensation circuit for solving the defects in the prior art. The connection state of wirings is displayed by LEDs visually, which saves the costs of hardware and software greatly. Meanwhile, the compensation circuit is used to compensate the transmission lines to reduce the impact of the newly added components such as LED on the transmission performance.

To achieve the above object, the following technical solution is adopted in the present invention.

An RJ45 connector with a light emitting diode and a compensation circuit comprises:
a voltage divider resistor R, a Zener diode D and the bi-color light emitting diode LED, wherein the voltage divider resistor R, the Zener diode D and the bi-color light emitting diode LED are serially connected between any two transmission lines of the RJ45 connector; and
a capacitance compensation circuit connected to the two transmission lines to perform capacitance compensation on the transmission lines.

According to a particular embodiment, the capacitance compensation circuit comprises a control unit and a capacitance compensation unit, wherein the control unit controls the capacitance compensation unit so as to determine a corresponding capacitance compensation value, and the capacitance compensation unit is connected to the transmission lines to perform compensation of the corresponding compensation value.

According to a particular embodiment, the capacitance compensation unit comprises a switch and a capacitor, and the control unit controls opening and closing of the switch in the capacitance compensation unit.

According to a particular embodiment, the RJ45 connector comprises a plurality of the capacitance compensation units.

According to a particular embodiment, the RJ45 connector is an RJ45 male connector, and further includes a network cable, a jumper wire sleeve, an IDC wire clamping cover, an IDC metal reed, a PCB, a metal reed and a PLUG casing.

According to a particular embodiment, the voltage divider resistor R, the Zener diode D, the bi-color light emitting diode LED and the IDC metal reed are provided on the PCB.

According to a particular embodiment, the RJ45 connector is an RJ45 female connector, and further includes a JACK body, a lower pin holder, a pin terminal, an inner body holder, a PCB, an IDC terminal, an IDC plastic seat and an IDC dust cover.

According to a particular embodiment, the voltage divider resistor R, the Zener diode D and the bi-color light emitting diode LED are provided on the PCB. According to a particular embodiment, the Zener diode D is used to supply power to the bi-color light emitting diode LED after the connector is connected to a terminal, so as to maintain a voltage of the bi-color light emitting diode LED stable.

According to a particular embodiment, the compensation capacitor is a gold finger capacitor or a chip capacitor.

The RJ45 connector with the light emitting diode according to the present invention have the following beneficial effects.
1. In the present invention, a structure of an existing RJ45 connector is used, and any two transmission lines are selected to be connected, without adding any contact or transmission line at the connector, which saves the cost of the connector.
2. In the present invention, the connection state of the information point is displayed by the LED visually, without additionally introducing a control host computer or supporting software to determine the connection state, which saves the cost of a wiring system greatly.
3. In the invention, the numbers of some products used in a computer room is further reduced by avoiding a double-distribution structure.
4. In addition to being connected with the wirings in the computer room, the RJ45 connector according to the present invention may be connected to the terminal at a client side to detect and manage the state of connection thereto.
5. The capacitance compensation circuit is used to perform compensation on the transmission lines to reduce the impact of the newly added voltage divider resistor R, for example, on the transmission performance of the transmission lines.
6. An ideal compensation for the value of capacitance C is obtained through the selection of the capacitance compensation circuit.

### BRIEF DESCRIPTION OF THE DRAWINGS

FIG. 1 is a structural diagram of an RJ45 connector with a light emitting diode and a compensation circuit according to the first embodiment;
FIG. 2 is a structural diagram of an RJ45 female connector;
FIG. 3 is a structural diagram of an RJ45 male connector;
FIG. 4 is a schematic diagram of a PCB of the RJ45 female connector;
FIG. 5 is a schematic diagram of a PCB of the RJ45 male connector; and
FIG. 6 is a structural diagram of a compensation circuit according to the second embodiment.

### DETAILED DESCRIPTION

The embodiments of the present invention are described in the following through specific examples, and one of ordinary skill in the art can easily understand other advantages and effects of the present invention according to the content disclosed in the specification. The present invention may also be implemented or applied through other different specific examples, and various modifications and variations may be made to the details in the specification on the basis of different opinions and applications without departing from the principle of the present invention. It should be noted that the following embodiments and features therein may be combined mutually in the case of no conflicts.

It should be noted that, the drawings provided in the following embodiment merely exemplarily describe a basic concept of the present invention, and the drawings merely show components related to the present invention, but are not drawn according to the numbers, shapes and sizes of components in actual implementation. The shape, numbers and proportion of each component can be changed at will in an actual implementation, and the layout of components may be more complicated.

The present invention is further described with reference to the accompanying drawings and embodiments which are not intended to limit the present invention.

### First Embodiment

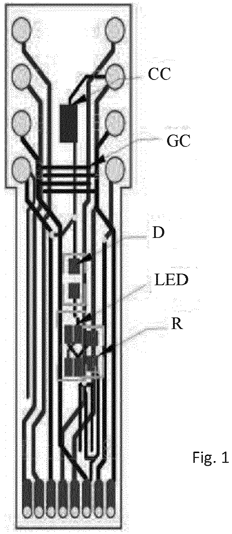

As shown in FIG. 1, the present embodiment proposes an RJ45 connector with a light emitting diode and a compensation circuit, comprising:
a voltage divider resistor R, a Zener diode D and the bi-color light emitting diode LED, wherein the voltage divider resistor R, the Zener diode D and the bi-color light emitting diode LED are serially connected between any two transmission lines of the RJ45 connector; and
a capacitance compensation circuit connected to the two transmission lines to perform capacitance compensation on the transmission lines.

Specifically, any two transmission lines are selected to be connected with the voltage divider resistor R, the Zener diode D and the bi-color light emitting diode LED. That is, a structure of an existing RJ45 connector is used, and any two transmission lines are selected for a connection, without adding any contact or transmission line at the connector, which saves the cost of the connector. Since the voltage divider resistor R, the Zener diode D and the bi-color light emitting diode LED are connected to the transmission lines, the transmission lines are unequal in length, and the transmission performance of the corresponding transmission lines is affected. Therefore, the present invention compensates the transmission lines. Specifically, compensation is performed by a capacitance compensation circuit, and the capacitance compensation circuit is connected to the two transmission lines to perform capacitance compensation on the transmission line, so as to reduce the influence of the introduction of the voltage divider resistor R and the like on the transmission performance of the transmission lines. The present invention does not limit the compensation capacitor. For example, a "gold finger" capacitor (tree capacitor) GC or a chip capacitor CC can be selected for the compensation.

When a tester is connected to the RJ45 connector, a voltage is input between the two transmission lines connected with the voltage divider resistor R, the Zener diode D and the bi-color light emitting diode LED. When a voltage is input, one of the LED in the bi-color LEDs will emit light to indicate that the RJ45 connector works normally, and wirings may be detected and managed. When the LED lamp does not emit light, it is indicated that a voltage of the tester is reverse or the RJ45 connector is abnormal.

A two-pin bi-color LED, adopted in the present invention, is integrally made of two LED chips of different colors connected in anti-parallel. When the bi-color LED is adopted, after the tester is connected to the RJ45 connector, a voltage is input between the two transmission lines selected to be connected with the voltage divider resistor R, the Zener diode D and the bi-color light emitting diode LED, and one LED chip of the bi-color LED will emit light. That is, one LED chip emits light when power applied to the two ends is positive, and the other LED chip emits light when the power applied to the two ends is negative.

For example, when a red-blue LED is adopted with the two pins marked as A and B, if the voltage applied to the LED is positive at A and negative at B, the LED will emit red light, and conversely, if the voltage applied to the LED is positive at B and negative at A, the LED will emit blue light.

By adopting a bi-color LED, the state of the RJ45 connector may be displayed in time, regardless of whether a forward or reverse voltage is input between the two transmission lines selected to be connected with the voltage divider resistor R, the Zener diode D and the bi-color light emitting diode LED.

When the wiring is managed, a terminal (such as a switch, a router, a computer, or the like) is connected to the RJ45 connector. At this point, the transmission line connected with the voltage divider resistor R, the Zener diode D and the bi-color light emitting diode LED is connected with a transformer coil in an apparatus in series, and since the coil has a small resistance, the voltage assigned to the LED will be decreased sharply. At this point, the Zener diode D supplies power to the LED to ensure that brightness of the LED is not affected after the terminal is connected to the RJ45 connector. Thus, in the present invention, a connection state of an information point is displayed by the LED visually, without additionally introducing a host computer to determine the connection state, which saves the cost of a wiring system greatly. At the same time, the numbers of some products used in a computer room are further reduced by avoiding a double-distribution structure.

Specifically, the connector according to the present invention includes an RJ45 male connector and an RJ45 female connector, and the RJ45 male and female connectors with LED lamps may be used independently or together, which is not limited herein.

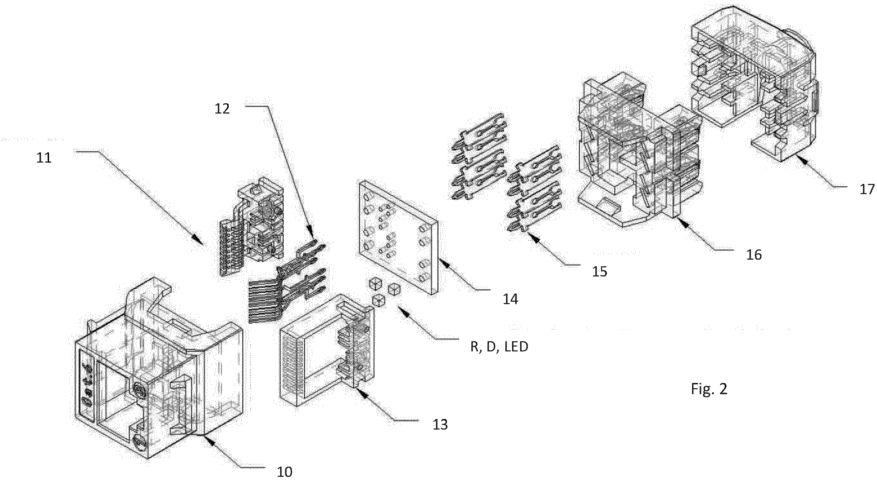

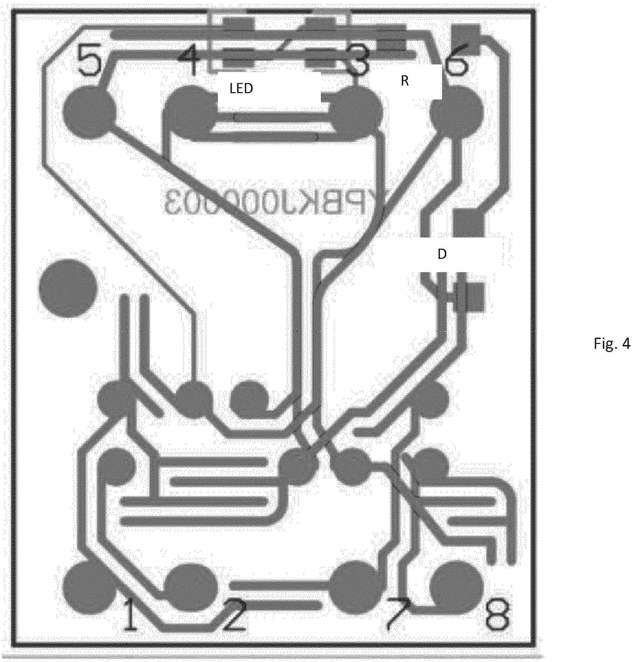

As shown in FIG. 2, the RJ45 female connector includes a JACK body 10, a lower pin holder 11, a pin terminal 12, an inner body holder 13, a PCB 14, an IDC terminal 15, an IDC plastic seat 16, an IDC dust cover 17, a voltage divider resistor R, a Zener diode D and the light emitting diode LED, wherein the voltage divider resistor R, the Zener diode D and the light emitting diode LED are provided on the PCB. The pin holder 11 is used to fix the shape and position of the pin terminal 12; the pin terminal 12 is used to be connected with an external male-connector conductor and the PCB 14 in the female connector; the PCB 14 is used to be connected with the pin terminal 12 and the IDC terminal 15, and meanwhile, a capacitor and an inductor are etched on the PCB 14 to compensate for an electrical performance of the entire female connector; the IDC terminal 15 is used to be connected with an external cable and the PCB 14 in the female connector; a circular clamping opening is provided at the IDC terminal 15, such that a core wire is positioned conveniently when pressed and mounted, which may effectively improve the efficiency of mounting the core wire. Due to the relatively close distance between the pin terminals, as well as the changing distances between the PLUG reeds, the IDC terminals 15 and the cables, for instance, mutual interference and impedance mismatch in the structure are caused during signal transmission; and thus, in the present invention, the capacitor or the inductor or a coupled line is etched on the PCB 14 to resist external interference effectively. As shown in FIG. 4, preferably, a connection line between the IDC terminal and the pin terminal is configured as a coupling line.

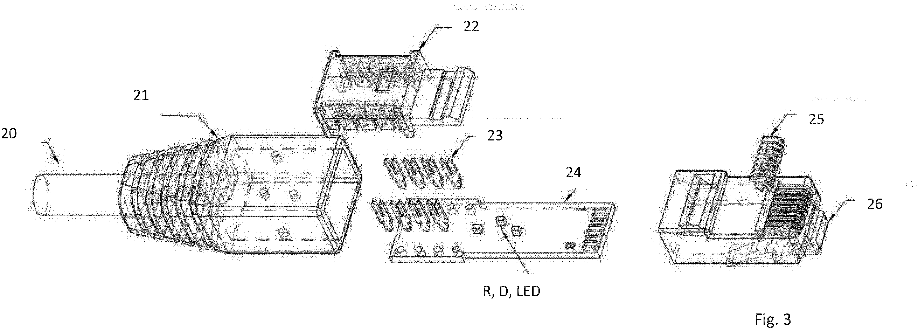

As shown in FIG. 3, the RJ45 male connector includes a network cable 20, a jumper wire sleeve 21, an IDC wire clamping cover 22, an IDC metal reed 23, a voltage divider resistor R, a Zener diode D, a bi-color light emitting diode LED, a PCB 24, a metal reed 25 and a PLUG casing 26, wherein the voltage divider resistor R, the Zener diode D, the bi-color light emitting diode LED and the IDC metal reed 23 are provided on the PCB.

When a reverse voltage is input into a tester, the bi-color light emitting diode LED does not emit light. At this point, the tester is required to be adjusted to input a forward voltage, so as to further determine a working status of the RJ45 connector. Therefore, a bi-color LED may be adopted in the present embodiment.

The IDC wire clamping cover 22 is used to fix the IDC metal reed 23; the IDC metal reed 23 is used to be connected with an external cable 20 and the PCB 24 in male connector; the PCB 24 is used to be connected with the IDC metal reed 23 and the PLUG reed, and meanwhile, a capacitor and an inductor are etched on the PCB 24 to compensate for an electrical performance of the entire male connector; the PLUG reed is used to be connected with an external female connector and the PCB 24 in the male connector.

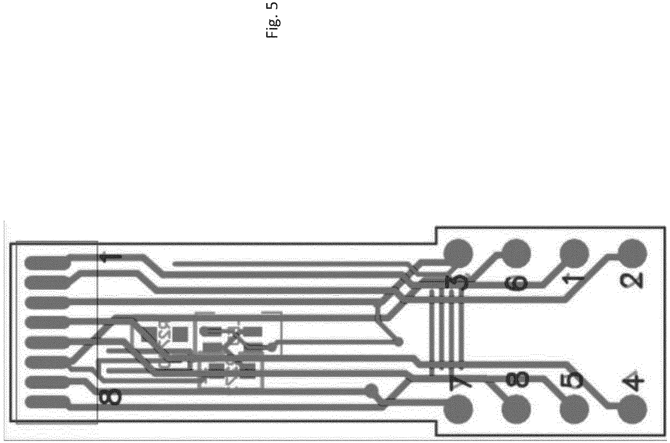

The capacitor or the inductor or a coupled line is etched on the PCB 24. As shown in Fig. 5, a connection line between the IDC terminal and the pin terminal is configured as a coupling line to resist external interference effectively. Preferably, in the present invention, the PCB may also be replaced with a flexible printed board. When the flexible printed board is adopted, the IDC wire clamping cover of the RJ45 male connector is replaced with a cable-wire limiting structure. Correspondingly, the IDC terminal is omitted in the RJ45 female connector, and the network cable is pressed under the PLUG reed directly. The rest of components are the same as those of the RJ45 connector with the PCB, and are not described again herein.

### Second Embodiment

In capacitance compensation, the value of capacitance C is often difficult to obtain an ideal compensation. Therefore, this embodiment further describes the capacitance compensation circuit.

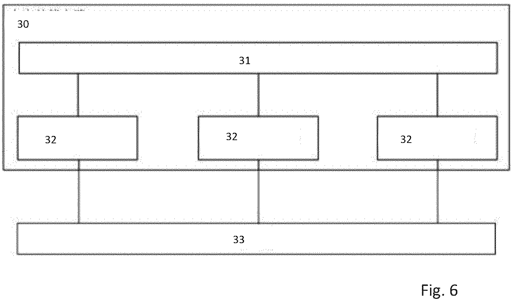

As shown in FIG. 6, the capacitance compensation circuit 30 comprises a control unit 31 and a capacitance compensation unit 32, wherein the control unit 31 controls the capacitance compensation unit 32, so as to determine a corresponding capacitance compensation value for the capacitance compensation unit 32 to perform the compensation. The capacitance compensation unit 32 is connected to the transmission lines 33 requiring the compensation so as to compensate them.

Specifically, the capacitance compensation unit 32 comprises a switch and a capacitor, and the control unit 31 determines whether to use the capacitor in the corresponding compensation unit 32 to compensate for the corresponding capacitance value by controlling opening and closing of the switch in the capacitance compensation unit 32. That is to say, the corresponding capacitor is used to compensate the transmission lines 33 when the switch is turned on, and the capacitor does not compensate the transmission lines when being closed.

To compensate the transmission lines more accurately, a plurality of capacitance compensation units 32 may be used at the same time for compensation on the transmission lines 33. In other words, one or more capacitance compensation units 32 may be selected for the compensation by controlling switches of a plurality of capacitance compensation units 32 so as to adapt to varied needs of transmission lines 33.

In the present invention, the capacitance compensation is controlled by a capacitance compensation circuit 30 to achieve compensation for different values of capacitance C through selection of different capacitance compensation units, so as to obtain an ideal compensation.

As such, in the RJ45 connector with the light emitting diode according to present invention, a structure of an existing RJ45 connector is used, and any two transmission lines are selected to be connected, without adding any contact or transmission line at the connector, which saves the cost of the connector; the connection state of the information point is displayed by the LED visually, without additionally introducing the control host computer or supporting software to determine the connection state, which saves the cost of the wiring system greatly; the numbers of some products used in the computer room are further reduced by avoiding the double-distribution structure; and in addition to being connected with the wiring in the computer room, the RJ45 connector according to the present invention may be connected to the terminal at the client side to detect and manage a connection thereto. In the present invention, a capacitance compensation circuit is used to perform compensation on the transmission lines to reduce the impact of the newly added voltage divider resistor R, for example, on the transmission performance of the transmission lines, and an ideal compensation for the value of capacitance C is obtained through the selection of the capacitance compensation circuit.

It is noted that the above is only the preferred embodiments of the present invention and the technical principles applied therein. Those skilled in the art will understand that the present invention is not limited to the specific embodiments described herein, and those skilled in the art may make various obvious changes, readjustments and substitutions without departing from the scope of protection of the present invention. Therefore, although the present invention has been described in detail with the above embodiments, the present invention is not limited to the above embodiments. Without departing from the concept of the present invention, more equivalent embodiments may be included.

## Claims

1. An RJ45 connector with a light emitting diode and a compensation circuit, comprising:
a voltage divider resistor (R), a Zener diode (D) and the bi-color light emitting diode (LED), wherein the voltage divider resistor (R), the Zener diode (D) and the bi-color light emitting diode (LED) are serially connected between any two transmission lines of the RJ45 connector, and the capacitance compensation circuit is connected to the two transmission lines to perform capacitance compensation on the transmission lines.

2. The RJ45 connector according to claim 1, wherein the capacitance compensation circuit (30) comprises a control unit (31) and a capacitance compensation unit (32), the control unit (31) controls the capacitance compensation unit (32) so as to determine a corresponding capacitance compensation value, and the capacitance compensation unit (32) is connected to the transmission lines (33) to perform compensation of the corresponding compensation value.

3. The RJ45 connector according to claim 2, wherein the capacitance compensation unit (32) comprises a switch and a capacitor, and the control unit (31) controls opening and closing of the switch in the capacitance compensation unit.

4. The RJ45 connector according to claim 3, comprising a plurality of the capacitance compensation units (32).

5. The RJ45 connector according to claim 1, wherein the RJ45 connector is an RJ45 male connector, and further comprises a network cable (20), a jumper wire sleeve (21), an IDC wire clamping cover (22), an IDC metal reed (23), a PCB (24), a metal reed (25) and a PLUG casing (26).

6. The RJ45 connector according to claim 5, wherein the voltage divider resistor (R), the Zener diode (D), the bi-color light emitting diode (LED) and the IDC metal reed (23) are provided on the PCB (24).

7. The RJ45 connector according to claim 1, wherein the RJ45 connector is an RJ45 female connector, and further comprises a JACK body (10), a lower pin holder (11), a pin terminal (12), an inner body holder (13), a PCB (14), an IDC terminal (15), an IDC plastic seat (16) and an IDC dust cover (17).

8. The RJ45 connector according to claim 7, wherein the voltage divider resistor (R), the Zener diode (D) and the bi-color light emitting diode (LED) are provided on the PCB (24).

9. The RJ45 connector according to claim 1, wherein the Zener diode (D) is used to supply power to the bi-color light emitting diode (LED) after the connector is connected to a terminal, so as to maintain a voltage of the bi-color light emitting diode (LED) stable.

10. The RJ45 connector according to claim 2, wherein the compensation capacitor is a gold finger capacitor or a chip capacitor.
